# EUROPEAN PATENT SPECIFICATION

(11) **EP 2 339 619 B1**
(45) Date of publication and mention of the grant of the patent: **07.01.2015**
(21) Application number: 10191826.6
(22) Date of filing: 19.11.2010
(51) Int. Cl.: H01L 23/66, H01L 23/373, H01L 23/498

(54) **Microwave integrated circuit provided with damping device for microphonic noise suppression.**
Mikrowellen-Integrierte Schaltung mit Dämpfungseinrichtung gegen mikrophonische Störungen
Circuit intégré à micro-onde avec dispositif pour supprimer le bruit microphonique

(30) Priority: 23.11.2009 IT MI20092050
(43) Date of publication of application: 29.06.2011
(73) Proprietor: SIAE Microelettronica S.p.A., 20093 Cologno Monzese (MI) (IT)
(72) Inventor: Favre, Gaetano, 20093, Cologno Monzese (MI) (IT); Pini, Alberto, 20093, Cologno Monzese (MI) (IT)
(74) Representative: Raimondi, Margherita

(56) References cited:
- JP-A- 3 261 203
- JP-A- 4 051 705
- US-A- 5 832 598
- US-A1- 2006 245 308
- US-A1- 2007 090 502
- US-A1- 2008 117 614

## Description

The present invention relates to a damping device for reducing the microphonic noise in oscillators. It is known in the technical sector relating to the transmission/reception of microwave frequency signals that the apparatus involved use one or more oscillators as microwave (MW) sources and it is also known that in the most recent apparatus said oscillators are also made using monolithic microwave integrated circuits (MMIC) which, by their very nature, are particularly sensitive to mechanical stresses which may cause phase fluctuations and/or, more generally, instability of the oscillating frequency.

This sensitivity of the oscillators has a negative effect on the transmission apparatus, creating instability in the spectrum and, in the case of digital signals, consequent transmission/reception errors. Methods are also known for reducing the impact which said mechanical disturbances or vibrations/impacts may have on the stability of the oscillators; these methods envisage essentially enclosing the electronic circuits which are to be protected inside mechanical containers which are damped using means on the outside of the container itself.

Said containers, inside which the oscillators are housed, have, however, a weight and size which are far greater than those of the circuits themselves and therefore require damping devices with large dimensions, thus complicating considerably the final radio system from the point of view of volume, ease of assembly and costs. In addition, these damped containers require flexible interconnections and joining elements which are complicated and costly.

From JP-03261203 it is also known to insert a conductive gel between the oscillator and a support panel in order to eliminate the mechanical vibrations and therefore the microphonic noise; the gel nevertheless has the drawback that it does not have precise geometric dimensions since, after application, it tends to retract on one side, while extending on the other side; this movement of the gel results in the need to provide connection wires (wire bonding) between the oscillator and the supporting printed circuit, which are of greater length and have curls so as to prevent them from breaking on the side where retraction of the gel occurs; these curls in the wires result in an increase in the parasitic inductances which, at microwave frequencies (>4GHz), open the electrical interconnection, causing malfunctioning of the oscillator which, since the nominal load is no longer present, oscillates at spurious frequencies.

Such a situation arises with the circuit described in JP-04051705 which uses resilient damping plates instead of the gel.

At microwave frequency said plates create not insignificant inductances and give rise to the same drawbacks and the malfunctioning mentioned above. US 2006/245308 **describes a stacked 3D structure wherein an interconnector device is interposed strategically between substrates carrying active circuits in order to achieve a stress damping result, i.e. an elastic deformation, in response to mechanical static loads. The interconnector device is formed by a core made out of layers of dielectric material (electrically and thermally non conductive) sandwiched between two metal laminates. Thermal dissipation from the upper stratum to the lower substrate and electric conduction is only effected through the thin laminates that enclose the dielectric, while no mention is made to microphonic noise suppression.** US 5 832 598 A **discloses a container for MMIC circuits enclosed by a protective cover.**

The technical problem which is posed therefore is to provide a device able to reduce the microphonic disturbances (phase fluctuations and frequency instability) caused by the vibrations and mechanical impacts affecting the oscillators which operate at microwave frequencies and are used in transmission/reception systems.

In connection with this problem it is also required that this device should have a low cost and be easy and economical to produce and assemble.

These results are achieved according to the present invention by an electronic circuit comprising at least one damped microwave (MW) oscillator circuit according to the characteristic features of Claim 1.

Further details may be obtained from the following description of a number of non-limiting examples of embodiment of the subject of the present invention provided with reference to the accompanying drawings in which:
- Figure 1: shows a schematic exploded view of a first embodiment of an MMIC circuit with damping device according to the present invention;
- Figure 2: shows a cross-sectional view of the circuit according to Fig. 1 in the assembled condition;
- Figure 3: shows a cross-sectional view of a second embodiment of a circuit with several oscillators and associated damping device according to the present invention;
- Figure 4: shows a cross-sectional view of a further application of the damping device according to the present invention; and
- Figure 5: shows a cross-sectional view of a sealed container for MMIC circuits with damping device according to the present invention.

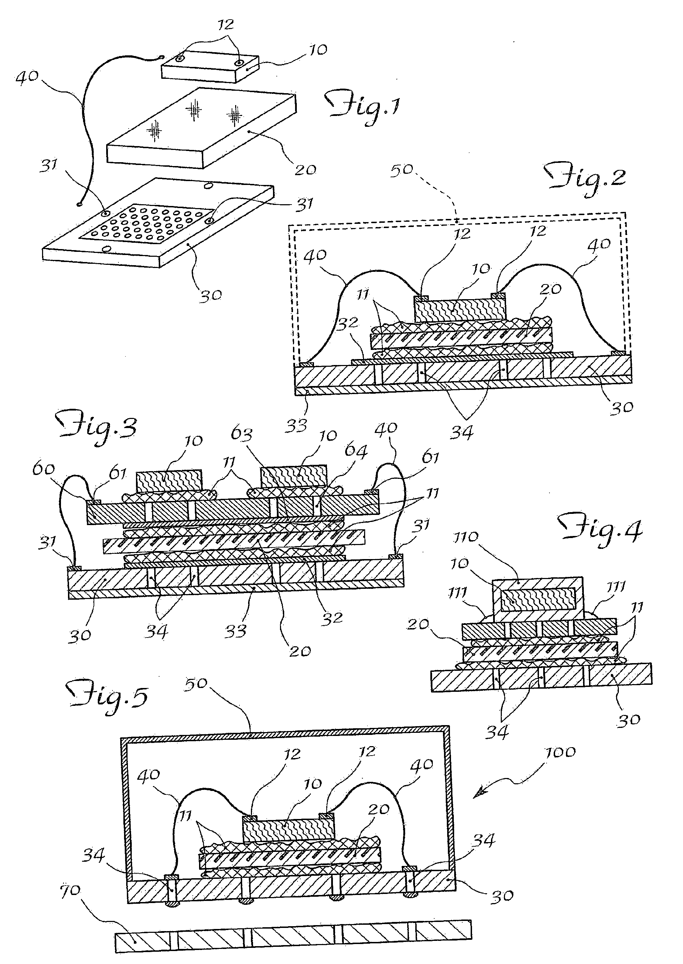

As shown in Fig. 1 an oscillator circuit with damping device according to the invention comprises:
- a monolithic microwave integrated circuit (MMIC) 10 which must be protected from mechanical stresses;
- a device for damping the mechanical stresses to which the integrated circuit 10 may be exposed, consisting of a layer 20 of resilient material containing conductive powders so that it acts as a good electrical and thermal conductor; with regard to the meaning and for the purposes of the present invention, said layer of resilient material will be referred to as a substrate 20 having suitable mechanical properties and a thickness which will be defined more fully below;
- a base printed circuit 30 onto which the resilient substrate 20 is applied;
- at least one electrical connection provided in the form of a conductive microwire 40, one end of which is thermocompressed onto a pad 12 of the integrated circuit 10 and the other end of which is thermocompressed onto a pad 31 of the printed circuit 30 (= wire bonding) so as to form the electrical connection between the two parts, while allowing relative movements of the integrated circuit 10 and the printed circuit 30.

The cross-sectional view of Figure 2 shows a monolithic microwave integrated circuit (MMIC) 10 which is bonded to the top side of a resilient substrate 20 by means of an epoxy resin 11 which is in turn electrically and thermally conductive; the bottom side of the resilient substrate 20 is bonded using epoxy resin 11 to a ground filler layer 32 of a base printed circuit 30 of the damped electronic circuit.

The ground filler layer 32 is in turn connected to a ground panel 33 arranged on the opposite side of the printed circuit 30, via metallized through-holes 34 which electrically connect the two sides of the printed circuit.

The area of the monolithic integrated circuit 10 is of the order of mm² and the thickness of the resilient substrate 20 is preferably in the region of 0.5 mm.

An example of material suitable for manufacturing the resilient substrate 20 consists of the product made by the company Chomerics called "cho-seal 1285" which has a Shore hardness (A scale) of 60-70, a tensile strength at breakage ≥ 1.38 Mpa with an elongation of 100-300%.

The monolithic integrated circuit (MMIC) 10 is connected electrically to the printed circuit paths 30 by means of microwires 40 with a length such as to allow relative oscillations of the integrated circuit itself and the base printed circuit 30, without introducing excessive parasitic inductance at the working frequencies, which at present may be compensated for, according to the prior art, by means of correct dimensioning of the bonding pads 31 on the printed circuit 30.

As shown in broken lines, it is envisaged that the oscillating circuit may be closed by a protective cover 50 made of metallic, plastic or absorbent material which is glued to the printed circuit board 30 using epoxy resins which are not necessarily conductive. The cover 50 may be provided with a layer of microwave-absorbent material in order to prevent any problems of electromagnetic compatibility.

Figure 3 shows a second embodiment of a damped electronic circuit according to the present invention where it is envisaged that there may be one or more monolithic microwave integrated circuits (MMIC) 10 which must be protected from vibrations or mechanical impacts; said MMIC 10 are in this case arranged on an intermediate printed circuit 60 and are connected thereto by means of conductive bonding or SMT (Surface Mounting Technology), according to the known art.

The intermediate printed circuit 60 is provided with paths, pads and metallized through-holes 64 for the electrical interconnection (ground, power supply, signals) of the monolithic integrated circuits (MMIC) 10.

The ground panel 63 of the intermediate printed circuit 60 is bonded using conductive epoxy resin 11 to a resilient substrate 20 already described in relation to the example of Figure 2 and in this case also the same conductive epoxy resin 11 is used for bonding the resilient substrate 20 to a ground filler layer 32 of the base printed circuit 30 of the damped electronic circuit.

Said ground filler layer 32 is connected to a ground panel 33 arranged on the opposite side of the printed circuit, via metallized through-holes 34 which electrically connect the two sides of the printed circuit board. As in the example of Fig. 1, the thickness of the resilient substrate 20 is in the region of 0.5 mm.

The flexible connections 40 which are used in wire bonding technology perform connection of the pads 61 of the intermediate printed circuit 60 to the pads 31 of the base printed circuit 30, allowing relative oscillation of the two printed circuits so as to allow damping of the oscillating circuit MMIC 10.

Preferably said wire-bonding microwires 40 for the electrical connections between the integrated circuit 10 and the base printed circuit 30 have a length of not more than 1 mm.

In addition, it is envisaged that each connection between integrated circuit and printed circuit comprises a pair of microwires 40 arranged in parallel in order to half the parasitic inductances.

Fig. 4 shows a further manner of applying the damping device according to the present invention; in this case, the integrated circuit 10 is in socalled "package" form, i.e. boxed inside an insulating container 110 provided with pins 111 for welding to an intermediate printed circuit 60 using SMT; the intermediate printed circuit 60 is bonded onto the damping layer 20 which is in turn bonded to a base printed circuit 30.

Figure 5 shows a cross-sectional view of a third embodiment of an electronic circuit damped against vibrations and mechanical impacts, according to the present invention.

This embodiment envisages enclosing one or more monolithic integrated circuits 10,110 and the associated damping device 20 inside a container 100 which can be mounted using SMT on an external printed circuit 70.

The monolithic microwave integrated circuit (MMIC) 10, similar to that seen in the previous examples, is bonded onto a resilient substrate 20 which forms the damping device. Th resilient substrate 20 is in turn bonded to the base printed circuit 30 and is provided with metallized holes 34 for transfer of the ground and the electric signals to joining points 34a situated on the other side thereof and suitable for surface mounting using SMT on the said external printed circuit 70.

A protective cover 50, which is made of metallic or plastic material, is bonded using epoxy sealing resins to the base printed circuit 30 so as to form a sealed container 100 for housing the monolithic integrated circuit 10 and the resilient substrate 20, suitable for mounting on the printed circuit 70 using SMT.

For clearer illustration, in Fig. 4 the circuit enclosed inside the container is formed according to the first embodiment, described in Fig. 2, but a person skilled in the art may envisage different damped circuits enclosed in a similar container.

It is therefore clear how the damping device according to the present invention can be used to provide microwave oscillators, and in particular MMIC circuits, which are protected from vibrations and/or mechanical impacts and therefore are able to reduce the associated microphonic problems, overcoming at the same time the problems associated with the formation of parasitic inductances resulting from excessively long metallic interconnections (wire bondings) which are the cause of malfunctioning of the oscillator itself.

In addition, the possibility of providing damped circuits enclosed inside a protective container means that storage and assembly of said circuits may be performed using automatic means, thereby further reducing production time and costs. Although described in connection with certain constructional forms and certain preferred examples of embodiment of the invention, it is understood that the scope of protection of the present patent is defined solely by the following claims.

## Claims

1. Electronic circuit comprising at least one oscillator of the monolithic microwave integrated (MMIC) type operating at frequencies higher than 4 GHz and at least one base printed circuit (30) for supporting the oscillator, **and a damping device** (20) **characterized in that said** damping device (20) consist**s** of a substrate (20), made of resilient **material containing** electrically and thermally conductive **powders,** arranged between the integrated circuit (10) and the base printed circuit (30) and suitable for suppressing microphonic noise.

2. Circuit according to Claim 1, **characterized in that** said substrate has a Shore hardness (A scale) of between 30 and 80.

3. Circuit according to Claim 2, **characterized in that** said substrate has a Shore hardness (A scale) preferably of between 60 and 70.

4. Circuit according to Claim 1, **characterized in that** said substrate has a tensile strength at breakage ≥1.38 Mpa with an elongation of 100-300%.

5. Electronic circuit according to Claim 1, **characterized in that** it comprises a layer of adhesive (11) arranged in between for joining together the resilient substrate (20), on the one hand, and the top side of the first printed circuit (30) and the bottom side of the integrated circuit (10), on the other hand.

6. Electronic circuit according to Claim 5, **characterized in that** said adhesive (11) is an epoxy resin which is electrically and thermally conductive.

7. Electronic circuit according to Claim 1, **characterized in that** it comprises microwires (40) or "wire bondings" with a length of not more than 1 mm for the electrical connections between the integrated circuit (10) and the base printed circuit (30).

8. Electronic circuit according to Claim 7, **characterized in that** it comprises a pair of microwires (40) arranged in parallel, for each connection.

9. Electronic circuit according to Claim 1, **characterized in that** said oscillator circuit (110) is a packaged MMIC.

10. Electronic circuit according to Claim 1, comprising several oscillator circuits (10;110), **characterized in that** it comprises an intermediate printed circuit (60) arranged between the integrated circuits (10;110) and the damping device (20) .

11. Electronic circuit according to Claim 10, **characterized in that** the resilient substrate (20), on the one hand, and the top side of the first printed circuit (30) and the bottom side of the integrated circuit (10), on the other hand, are joined together by adhesive means (11).

12. Electronic circuit according to Claim 11, **characterized in that** it comprises microwires (40) for forming electrical connections (wire bondings) between the intermediate printed circuit (60) and the base printed circuit (30).

13. Electronic circuit according to Claim 1, **characterized in that** it comprises a cover (50) fastened to the base printed circuit (30) and able to enclose the said electronic circuit.

14. Electronic circuit according to Claim 13, **characterized in that** the cover (50) is made of / comprises a microwave-absorbing material.

15. **Electronic circuit according to any of the preceding claims characterized in that it is in the form of a sealed c**ontainer (100) **comprising** at least one closing cover (50) fixed to the said base printed circuit (30).

16. E**lectronic circui**t according to Claim 15, **characterized in that** said cover (50) is sealed onto the base printed circuit (30).

17. E**lectronic circuit** according to Claim 16, **characterized in that** the outside surface of the container of said base printed circuit (30) has contact points (34a) situated in the region of metallized holes in the said printed circuit (30) for performing joining together thereof **and/or for surface mounting on an external printed circuit (70).**

## Patentansprüche

1. Elektronische Schaltung, umfassend mindestens einen Oszillator vom Typ eines monolithischen integrierten Mikrowellenbausteins (MMIC), der bei Frequenzen oberhalb von 4 GHz arbeitet, und mindestens eine Basisleiterplatte (30) zum Tragen des Oszillators, und eine Dämpfungseinrichtung (20), **dadurch gekennzeichnet, dass** die Dämpfungseinrichtung (20) aus einem Substrat (20) besteht, welches aus einem elastischen Werkstoff gefertigt ist, der elektrisch und thermisch leitende Pulver enthält, angeordnet zwischen der integrierten Schaltung (10) und der Basisleiterplatte (30), und außerdem geeignet zum Unterdrücken von Mikrofonie-Rauschen.

2. Schaltung nach Anspruch 1, **dadurch gekennzeichnet, dass** das Substrat eine Shore-A-Härte zwischen 30 und 80 aufweist.

3. Schaltung nach Anspruch 2, **dadurch gekennzeichnet, dass** das Substrat eine Shore-A-Härte von vorzugsweise zwischen 60 und 70 aufweist.

4. Schaltung nach Anspruch 1, **dadurch gekennzeichnet, dass** das Substrat eine Bruch-Zugfestigkeit von ≥1,38 MPa bei einer Dehnung von 100-300 % aufweist.

5. Elektronische Schaltung nach Anspruch 1, **dadurch gekennzeichnet, dass** sie eine Klebstoffschicht (11) zur Verbindung des elastischen Substrats (20) einerseits auf der Oberseite der ersten Leiterplatte (30) und andererseits auf der Bodenseite der integrierten Schaltung (10) aufweist.

6. Elektronische Schaltung nach Anspruch 5, **dadurch gekennzeichnet, dass** der Klebstoff (11) ein Epoxyharz ist, welches elektrisch und thermisch leitend ist.

7. Elektronische Schaltung nach Anspruch 1, **dadurch gekennzeichnet, dass** sie Mikrodrähte (40) oder "Draht-Bondverbindungen" mit einer Länge von nicht mehr als 1 mm für die elektrischen Verbindungen zwischen der integrierten Schaltung (10) und der Basisleiterplatte (30) aufweist.

8. Elektronische Schaltung nach Anspruch 7, **dadurch gekennzeichnet, dass** sie ein Paar für jede Verbindung parallel angeordneter Mikrodrähte (40) aufweist.

9. Elektronische Schaltung nach Anspruch 1, **dadurch gekennzeichnet, dass** die Oszillatorschaltung (110) ein verpacktes MMIC ist.

10. Elektronische Schaltung nach Anspruch 1 umfassend mehrere Oszillatorschaltungen (10; 110), **dadurch gekennzeichnet, dass** sie eine Zwischenleiterplatte (60) aufweist, angeordnet zwischen den integrierten Schaltungen (10; 110) und der Dämpfungseinrichtung (20).

11. Elektronische Schaltung nach Anspruch 10, **dadurch gekennzeichnete, dass** das elastische Substrat (20) einerseits auf der Oberseite der ersten Leiterplatte (20) und andererseits auf der Unterseite der integrierten Schaltung (10) mittels Klebstoff (11) verbunden ist.

12. Elektronische Schaltung nach Anspruch 11, **dadurch gekennzeichnet, dass** sie Mikrodrähte (40) zur Bildung elektrischer Verbindungen (Draht-Bondverbindungen) zwischen der Zwischenleiterplatte (60) und der Basisleiterplatte (30) aufweist.

13. Elektronische Schaltung nach Anspruch 1, **dadurch gekennzeichnet, dass** sie eine an der Basisleiterplatte (30) befestigte Abdeckung (50) zum Umschließen der elektronischen Leitung aufweist.

14. Elektronische Schaltung nach Anspruch 13, **dadurch gekennzeichnet, dass** die Abdeckung (50) aus mikrowellenabsorbierendem Werkstoff besteht oder einen solchen Werkstoff aufweist.

15. Elektronische Schaltung nach einem der vorhergehenden Ansprüche, **dadurch gekennzeichnet, dass** sie in Form eines abgedichteten Behältnisses (100) ausgebildet ist, umfassend mindestens eine umschließende Abdeckung (50), die an der Basisleiterplatte (30) fixiert ist.

16. Elektronische Schaltung nach Anspruch 15, **dadurch gekennzeichnet, dass** die Abdeckung (50) an der Basisleiterplatte (30) abgedichtet ist.

17. Elektronische Schaltung nach Anspruch 16, **dadurch gekennzeichnete, dass** die Außenfläche des Behälters der Basisleiterplatte (30) Kontaktpunkte (34a) aufweist, die in dem Bereich metallisierter Löcher in der Leiterplatte (30) gelegen sind, um untereinander verbunden zu sein und/oder zur Oberflächen-Montage auf einer externen Leiterplatte (70).

## Revendications

1. Circuit électronique comportant au moins un oscillateur du type intégré monolithe pour micro-ondes (MMIC) fonctionnant à des fréquences supérieures à 4GHz et au moins un circuit imprimé de base (30) pour supporter l'oscillateur, et un dispositif d'amortissement (20) **caractérisé en ce que** ledit dispositif d'amortissement (20) est constitué d'un substrat (20), fait d'un matériau élastique contenant des poudres conductrices électriquement et thermiquement, agencé entre le circuit intégré (10) et le circuit imprimé de base (30) et approprié pour supprimer le bruit microphonique.

2. Circuit selon la revendication 1, **caractérisé en ce que** ledit substrat présente une dureté Shore (échelle A) comprise entre 30 et 80.

3. Circuit selon la revendication 2, **caractérisé en ce que** ledit substrat présente une dureté Shore (échelle A) comprise, de préférence, entre 60 et 70.

4. Circuit selon la revendication 1, **caractérisé en ce que** ledit substrat présente une résistance à la rupture par traction ≥ 1,38 Mpa avec un allongement de 100 à 300%.

5. Circuit électronique selon la revendication 1, **caractérisé en ce qu'**il comprend une couche d'adhésif (11) intercalée pour relier le substrat élastique (20) d'une part, et le côté supérieur du premier circuit imprimé (30) et le côté inférieur du circuit intégré (10), d'autre part.

6. Circuit électronique selon la revendication 5, **caractérisé en ce que** ledit adhésif (11) est une résine époxy qui est conductrice électriquement et thermiquement.

7. Circuit électronique selon la revendication 1, **caractérisé en ce qu'**il comprend des micro-fils métalliques (40) ou des « liaisons filaires » dotées d'une longueur qui n'est pas supérieure à 1 mm pour les connexions électriques entre le circuit intégré (10) et le circuit imprimé de base (30).

8. Circuit électronique selon la revendication 7, **caractérisé en ce qu'**il comprend une paire de micro-fils métalliques (40) disposés en parallèle, pour chaque connexion.

9. Circuit électronique selon la revendication 1, **caractérisé en ce que** ledit circuit oscillateur (110) est un circuit MMIC conditionné.

10. Circuit électronique selon la revendication 1, comportant plusieurs circuits oscillateurs (10 ; 110), **caractérisé en ce qu'**il comporte un circuit imprimé intermédiaire (60) agencé entre les circuits intégrés (10 ; 110) et le dispositif d'amortissement (20).

11. Circuit électronique selon la revendication 10, **caractérisé en ce que** le substrat élastique (20) d'une part, et le côté supérieur du premier circuit imprimé (30) et le côté inférieur du circuit intégré (10) d'autre part, sont reliés l'un à l'autre par des moyens adhésifs (11).

12. Circuit électronique selon la revendication 11, **caractérisé en ce qu'**il comprend des micro-fils métalliques (40) pour former des connexions électriques (liaisons filaires) entre le circuit imprimé intermédiaire (60) et le circuit imprimé de base (30).

13. Circuit électronique selon la revendication 1, **caractérisé en ce qu'**il comprend un couvercle (50) fixé sur le circuit imprimé de base (30) et pouvant enfermer ledit circuit électronique.

14. Circuit électronique selon la revendication 13, **caractérisé en ce que** le couvercle (50) est constitué d'un / comprend un, matériau absorbant les micro-ondes.

15. Circuit électronique selon l'une quelconque des revendications précédentes, **caractérisé en ce qu'**il se présente sous la forme d'un boîtier étanche (100) comportant au moins un couvercle de fermeture (50) fixé au dit circuit imprimé de base (30).

16. Circuit électronique selon la revendication 15, **caractérisé en ce que** ledit couvercle (50) est scellé hermétiquement sur le circuit imprimé de base (30).

17. Circuit électronique selon la revendication 16, **caractérisé en ce que** la surface extérieure du boîtier dudit circuit imprimé de base (30) présente des points de contact (34a) situés dans la zone de trous métallisés dans ledit circuit imprimé (30) afin de réaliser la connexion entre eux et/ou pour un montage en surface sur un circuit imprimé externe (70).
